Europäisches Patentamt

European Patent Office

Office européen des brevets

(11) Publication number: **0 053 013**
**B1**

(12) **EUROPEAN PATENT SPECIFICATION**

(45) Date of publication of patent specification: 05.03.86

(21) Application number: 81305480.6

(22) Date of filing: 20.11.81

(51) Int. Cl.⁴: **H 01 L 29/62**, H 01 L 29/28, G 11 C 11/34

(54) Non-volatile semiconductor memory device.

(30) Priority: 20.11.80 JP 163596/80

(43) Date of publication of application:
02.06.82 Bulletin 82/22

(45) Publication of the grant of the patent:
05.03.86 Bulletin 86/10

(84) Designated Contracting States:
DE FR GB NL

(56) References cited:
EP-A-0 025 311
DE-A-2 824 419
DE-B-2 636 350
US-A-4 047 974
US-A-4 057 820

(73) Proprietor: FUJITSU LIMITED
1015, Kamikodanaka Nakahara-ku
Kawasaki-shi Kanagawa 211 (JP)

(72) Inventor: Togei, Ryoiku
23-6, Narusedai 2-chome
Machida-shi Tokyo 194 (JP)

(74) Representative: Sunderland, James Harry et al
HASELTINE LAKE & CO Hazlitt House 28
Southampton Buildings Chancery Lane
London WC2A 1AT (GB)

Courier Press, Leamington Spa, England.

## Description

The present invention relates to a non-volatile semiconductor memory device.

Some types of non-volatile semiconductor memory device have already been proposed which each provide a structure similar to that of an ordinary MIS FET.

One type of memory device provides many traps for charges beneath gate insulating film and stored binary states are represented by changes of gate threshold voltage caused by charges in these traps. A memory device of this type is disclosed, for example, in U.S. Patent No. 3,549,911.

Another type of memory·device, using a floating gate for storing charges is disclosed, for example, in U.S. Patents Nos. 3,500,142; 3,797,000; and 3,825,946.

For these types of non-volatile memory devices, two kinds of mechanism are utilised for injection of charges into charge traps or into the floating gate for data writing.

One mechanism employs tunnel injection — charges are injected through very thin insulating film by means of the tunnel effect — and the other mechanism employs avalanche injection — hot carriers generated by the avalanche phenomenon are injected through comparatively thick insulating film.

These methods are described in the above-mentioned U.S. Patents.

Use of tunnel injection involves a disadvantage in that insulating film thickness, even at maximum, through which charges can pass by the tunnel phenomenon, is about 100 Å and such ultra-thin insulating film is inferior in reproducibility and tends to have many pin holes therein which makes the charge storing period short. .

Using avalanche injection it is possible to inject charge through a considerable thickness of insulating film, for example through a thickness of 1000 Å. However, repeated injection of avalanche hot carriers can easily result in damage to the insulating film which has an adverse effect on charge storing characteristics. Therefore, the number of repetitions of write operation is liable to be restricted and this is undesirable for memory devices. A further serious disadvantage of the avalanche injection mechanism is that application of a voltage as high as, for example, 35 volts is required for write operation.

Write voltages required for memory devices of both the above mentioned types are disadvantageously high.

The various problems explained above result from the fact that write operation in the above-mentioned types of memory device essentially involves injection of charges through insulating film. It is difficult to eliminate the problems explained above so long as such write operations are utilised.

In addition to non-volatile memory devices of the types mentioned above, there is also known a non-volatile memory device utilising remnant polarisation of gate insulating film consisting of ferroelectric material, which is disclosed, for example, in U.S. patent No. 2,791,760. In such a device, write voltage is extremely high. Moreover, the ferroelectric material has not yet been fully investigated for adaptability to semiconductor processes and this memory device is still far from practical application. It may be desirable from a practical point of view to utilise semiconductor-insulator structures of silicon (Si)- silicon dioxide (SiO$_2$) on silicon nitride (Si$_3$N$_4$), which are already established in semiconductor device technology.

According to the present invention there is provided a semiconductor memory device comprising;

a semiconductor substrate of a first conductivity type,

source and drain regions of a second conductivity type, opposite to the first conductivity type, formed in the substrate,

a semiconductor layer of a material which is insulating under normal conditions of operation but is conducting and allows injection or ejection of charges when it is subjected to an electric field of an intensity higher than a specific value, the material having energy levels capable of trapping charges, formed between the source and drain regions above the substrate,

an insulating film formed on the semiconductor layer,

a gate electrode formed on the insulating film, and

source and drain electrodes in contact with the source and drain regions respectively, at least one of the source and drain electrodes being in contact with the semiconductor layer.

An embodiment of the present invention provides a non-volatile memory device which is rewritable and which can hold stored data even after supply of power source voltage is removed.

An embodiment of the present invention can provide a non-volatile semiconductor memory device which has reduced write voltage as compared with previous non-volatile semiconductor memory devices.

An embodiment of the present invention can provide a non-volatile memory device in which the problem of destruction of stored charges due to the presence of pin-holes in insulating film, which problem is often observed in previous devices, is substantially absent.

An embodiment of the present invention can provide a non-volatile memory device which does not suffer a deterioration of charge storing characteristics after repeated write operations.

An embodiment of the present invention can provide a non-volatile memory device in which write operation without charge injection through insulating film is realised, and for which, therefore, the write characteristic and stored charge sustaining characteristic do not depend on the characteristic of insulating film.

An embodiment of the present invention can provide a non-volatile memory device which can be produced with materials ordinarily used in existing semiconductor techniques, without the need for the use of special materials such as ferroelectric material.

In a non-volatile semiconductor memory device embodying the present invention the semiconductor layer, having the property that its conductivity can be changed from insulative to conductive by a field effect and having energy levels capable of trapping charges, is preferably of an amorphous semiconductor.

A further insulating film may be provided between the substrate and the semiconductor layer. This is not essential for the device to function but it may advantageously be provided to offer a conventional insulator-semiconductor interface structure which would facilitate the design of the device parameters and further reproducibility.

A non-volatile memory device embodying the present invention is different from any existing type of non-volatile memory device in that a semiconductor layer the conductivity of which can be changed over a range, for example of $10^4$ or more, by a field effect, in particular an amorphous semiconductor layer, is used for capturing and storing charges. As is well known, amorphous semiconductor shows a resistivity of $10^4$ ohm-cm or higher when undoped or when lightly doped.

Embodiments of the present invention utilise this property of, for example, amorphous semiconductor. That is, use is made of the fact that amorphous semiconductor has an insulation characteristic under normal conditions but allows injection and ejection of charges, depending upon the direction of applied field, when a field is applied which has an intensity higher than a specific intensity, and, in addition, the fact that charges once injected do not leak out to external circuits until a field having an intensity higher than the specific intensity is applied again.

Amorphous semiconductor can effectively be charged with comparative ease by the injection of charges, and can then sustain such injected charges because it has many charge capturing levels as compared with crystalline semiconductor.

Injection of charges, in this case, can readily be realised by utilizing the semiconductor field effect whereby resistance changes when field is applied because of variation of the energy band structure of the amorphous semiconductor caused by applied field.

Thus, in embodiments of this invention, charge injection into a amorphous semiconductor layer is carried out directly from the source electrode and/or the drain electrode, not via insulating film, when a high intensity field is applied to the amorphous semiconductor. Therefore, the source electrode and/or drain electrode is or are directly in contact with the amorphous semiconductor layer. Because of the need to apply a high field intensity, it is required to apply a higher voltage to the gate electrode for writing as compared with the voltage applied for readout operation, but that higher voltage need not be as high as write voltages required in previously proposed non-volatile memory devices. After the high field intensity required for write operation is removed, the amorphous semiconductor layer functions substantially as an insulating layer and therefore an unwanted conductive path is not formed even though the source electrode and/or the drain electrode is or are in contact therewith. The charges stored in the amorphous semiconductor layer modify the charge distribution at the surface of the substrate thereunder, and change the current-voltage characteristics between source and drain of the device, to enable readout operation.

In preferred embodiments of the present invention, amorphous silicon is used as the amorphous semiconductor. For the substrate, p type or n type single crystal silicon is desirable. Insulating film provided between the substrate and amorphous silicon layer may be silicon dioxide film having a desired thickness, or silicon nitride film, for example. The boundary structure between the substrate and insulating film thus formed is similar to that of a conventional MIS FET. This means that such a memory device embodying the present invention has no particular problems in relation to reproducibility and stability. During readout, such a memory device operates as in the case of an ordinary MIS FET because the stored data is detected during readout operation on the basis of a difference in gate threshold voltage — this is detected by testing the conductive condition between the source and drain regions — which depends upon the stored charges.

When the first insulating layer is omitted, the amorphous silicon layer itself functions as a gate insulator for the MIS FET operation during readout operation.

For erasing stored data, a high intensity field is applied in a direction the reverse of the direction of the field applied in write operation, and thereby charges of a polarity opposite to the stored charges are injected into the amorphous semiconductor layer. In a similar manner, stored charges may be ejected to perform the erase operation. As an alternative to such electrical erasing methods, means such as irradiation with ultra-violet rays or high temperature heating can be employed.

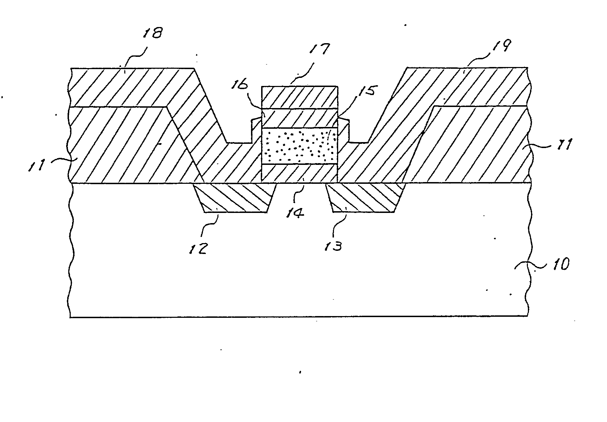

Reference is made, by way of example, to the accompanying drawing, in which:—

The figure is a schematic sectional view of a non-volatile memory device embodying the present invention.

In the illustrated non-volatile memory device, a substrate 10 is of n (or, alternatively of p) type single crystal silicon and a thick field insulation film 11 is provided on a surface of the substrate. $p^+$ (or, alternatively $n^+$) source and drain regions 12 and 13 respectively, are formed within the substrate 10. A first gate insulating film 14, consisting of insulator such as silicon dioxide or silicon nitride, is formed in close contact with the substrate surface between the source and drain regions. On the first gate insulating film 14 an undoped amorphous silicon layer 15 is formed, a second gate insulating film 16 is formed on the layer 15 and a gate electrode (control gate electrode) 17 is formed on the film 16. The second gate insulating film 16 may be of silicon dioxide or silicon nitride, whilst the gate electrode 17 may be an ordinary metallic electrode, for example of aluminium. A source electrode 18 and a drain electrode 19, of metal such as aluminium or of conductive semiconductor such as doped polysilicon, are respectively connected to the source region 12 and the drain region 13, in ohmic contact therewith, and also contact the amorphous silicon layer 15.

The amorphous silicon layer 15 usually has a high resistivity and functions substantially as an insulating layer so that a conductive path is not formed between the source and drain electrodes · via the amorphous silicon layer.

In the illustrated embodiment of the present invention, a field is applied to the amorphous semiconductor layer 15 by applying a voltage to the electrode 17 above the amorphous semiconductor layer. As explained above, charge injection becomes possible when the field is applied to the amorphous semiconductor layer 15, and charge is injected mainly from the source electrode 18 or drain electrode 19 via a region near the boundary between the amorphous semiconductor layer 15 and the insulating film 16, because charges are mainly injected via an inversion layer formed in the vicinity of that boundary in the amorphous semiconductor layer due to the application of the field. For this reason, it is desirable that the source electrode 18 and/or the drain electrode 19 be in contact with the boundary between the amorphous semiconductor layer 15 and the insulating film 16, as shown in the Figure.

In the illustrated device embodying the present invention, voltages of different polarity are applied to the control gate electrode 17 and to the electrodes 18 and/or 19 during charge injection. Therefore, the field applied from the control gate electrode 17 is modified a little by the field applied from the electrode 18 and/or 19 in the area of the amorphous semiconductor layer near to the electrode 18 and/or the electrode 19. Thus, field intensity in the amorphous semiconductor layer 15 achieves a maximum at the centre of that layer between the electrodes 18 and 19. Accordingly, charges injected from electrode 18 and/or 19 advance to an area central between the source and drain regions in the amorphous semiconductor layer.

Here, when the voltage being supplied to the control gate electrode 17 is interrupted, charges are captured in the amorphous semiconductor layer 15 and the captured charges are not ejected even when a relatively low voltage is applied to the source, drain electrodes for readout operations unless a comparatively high voltage is also applied to the control gate electrode 17. It is thus assumed that charges captured in the amorphous semiconductor layer 15 are mainly concentrated in an area near the boundary of the layer 15 with the insulating film 16, and such charges are not output to external circuits even when field is applied from the source and drain electrodes 18, 19 unless a sufficiently high voltage is applied to the control gate electrode 17.

When charges are thus captured in the amorphous semiconductor layer 15, the threshold voltage $V_{TH}$ for switching ON and OFF a channel between the source region 12 and drain region 13 changes (has a value different from the value effective when no charges are captured) and this conditions is held stably.

The threshold voltage $V_{TH}$, is about 2 V to 3 V, in terms of absolute value (that is, ignoring the sign of the voltage), even at its maximum, whilst a voltage of 10 V or higher in terms of absolute value must be applied to the control gate electrode 17 for charge injection or ejection. Therefore, charges captured in layer 15 will not be ejected whilst the device is operated as an ordinary MIS type transistor.

The "write", "readout" and "erasing" operations of the illustrated semiconductor memory device embodying the present invention will be explained below.

By way of example, it is assumed hereunder that the semiconductor substrate 10 is of n conductivity type semiconductor, that the source and drain regions 12, 13 are $p^+$ type diffusion regions, and that a p channel type semiconductor memory device is obtained.

A "write" operation is carried out as follows. Holes are injected into the amorphous semiconductor layer 15 by applying a positive voltage to at least one of the source and drain electrodes 18 and 19 whilst maintaining the control gate electrode 17 at a negative "write" voltage of about 10 V or higher. Then, supply of voltage to the source electrode 18 and/or drain electrode 19 is interrupted whilst supply of "write" voltage to the control gate electrode 17 is maintained. Thereafter, supply of "write" voltage to the control gate electrode 17 is terminated. Thereby, the holes injected into the amorphous semiconductor layer 15 are captured.

A "readout" operation is carried out as follows. For example, a voltage is applied to each electrode in such a manner that the source region 12 is kept at ground potential or at a positive potential, whilst the drain region 13 is kept at a negative potential with respect to the source potential. Then the ON-OFF condition between the source and drain regions is detected by applying a negative voltage of at most about 2 V to 3 V to the control gate electrode 17. When holes have been captured in the amorphous semiconductor layer 15, the threshold voltage $V_{TH}$ is reduced and therefore the area (channel) between the source and drain regions is kept in the OFF condition. Thereby, data stored by capture of charges can be read.

An "erasing" operation is carried out as follows. Electrons are injected into the amorphous semiconductor layer 15 by applying a negative voltage to at least one of the source and drain electrodes 18 and 19 whilst the control electrode 17 is kept at a positive voltage of about 10 V or higher.

Capture of charges in the amorphous semiconductor layer involves the capture of charges by energy levels, existing in an energy gap, peculiar to the amorphous condition, but the amount of charge captured depends on temperature. That is, the amount of charge captured changes in dependence upon the amount of thermal energy supplied externally of the device. It is possible to make use of this dependency on temperature in "write", "readout" and "erasing" operations.

As will be clear from an understanding of the operational principles of a semiconductor memory device embodying this invention, the present invention does not essentially require the presence of an insulating film such as film 14 shown in the Figure. However, the insulating film 14 is desirable in order to improve that the same channel formation characteristics apply between the source and drain regions as apply in conventional MIS FET's. In addition, although both source electrode 18 and drain electrode 19 are shown connected to the amorphous semiconductor layer 15 in the Figure, it will be understood from the operating principle of the device that only one need be connected.

Moreover, it is particularly desirable for embodiments of the present invention that the charge capturing region consists of semiconductor in the amorphous condition, but use may be made of semiconductor containing some impurities or exhibiting crystalline characteristics to some extent if the semiconductor shows sufficiently high resistivity ($10^4$ ohm-cm or higher) when no electric field is applied thereto and if the resistivity can be modified by applying an electric field. In some cases, charges can be captured effectively by allowing an adequate amount of impurities to be contained. In a device embodying the present invention, no special consideration need be given to the materials of the semiconductor substrate and source, gate and control electrodes.

Amorphous semiconductor used in embodiments of the present invention can be coated on the substrate by conventional techniques such as sputtering or evaporation. In particular, it is well known in semiconductor technology that amorphous silicon can be coated by a method involving plasma decomposition of monosilane — namely the glow discharge method —, and also by reactive sputtering or by chemical vapor deposition.

The illustrated memory device embodying the present invention is equivalent to conventional MIS FET's in terms of materials and manufacturing methods except for the amorphous semiconductor layer 15. Thus, a memory device embodying the present invention can be obtained by employing well known amorphous semiconductor coating technology as explained above and ordinary MIS FET manufacturing processes.

An embodiment of the present invention provides a non-volatile memory device which stores data by capturing charges in an amorphous semiconductor layer. This amorphous semiconductor layer is provided between the gate electrode and the semiconductor substrate of the device with an insulating film between the amorphous semiconductor layer and the gate electrode with the amorphous semiconductor layer in contact at an edge with at least one of the source and drain electrodes.

When a high voltage (10 V or higher) is applied to the gate electrode an electric field is generated and thereby charges are injected into the amorphous semiconductor layer from the source and/or drain electrodes and write operation is thus effected. Erasing operation is carried out by injection of charges of inverse polarity.

The memory device embodying the present invention can offer the advantages of low operating voltage and excellent charge sustaining characteristics, resulting from the fact that write operation is attained independently of gate insulating film.

## Claims

1. A semiconductor memory device comprising:
a semiconductor substrate (10) of a first conductivity type,
source and drain regions (12, 13) of a second conductivity type, opposite to the first conductivity type, formed in the substrate,
a semiconductor layer (15) of a material which is insulating under normal conditions of operation but is conducting and allows injection or ejection of charges when it is subjected to an electric field of an intensity higher than a specific value, the material having energy levels capable of trapping charges, formed between the source and drain regions above the substrate,
an insulating film (16) formed on the semiconductor layer,
a gate electrode (17) formed on the insulating film, and
source and drain electrodes (18, 19) in contact with the source and drain regions respectively, at least one of the source and drain electrodes being in contact with the semiconductor layer.

2. A device as claimed in claim 1, wherein the semiconductor layer is of amorphous semiconductor.

3. A device as claimed in claim 2, wherein the semiconductor layer is of amorphous silicon.

4. A device as claimed in claim 1, 2 or 3, comprising a further insulating film (14) between the substrate and the semiconductor layer.

5. A device as claimed in claim 4, wherein the further insulating film is of silicon dioxide or silicon nitride.

6. A device as claimed in any preceding claim, wherein at least one of the source and drain electrodes contacts the interface between the semiconductor layer and the insulating film formed thereon.

**Patentansprüche**

1. Halbleiterspeicheranordnung mit
einem Halbleitersubstrat (10) von einem ersten Leitfähigkeitstyp,
Source- und Drainbereichen (12, 13), die von einem zweiten, zum ersten Leitfähigkeitstyp entgegengesetzten Leitfähigkeitstyp und in dem Substrat ausgebildet sind,
einer Halbleiterschicht (15) aus einem Material, welches unter normalen Betriebsbedingungen isoliert, jedoch dann, wenn es einem elektrischen Feld mit einer Intensität höher als ein vorbestimmter Wert unterworfen wird, leitend ist und die Injektion oder Ejektion von Ladungen erlaubt, wobei das Material Energiepegel hat, die fähig sind, Ladungen einzufangen, welche zwischen den Source- und Drainbereichen oberhalb des Substrats gebildet werden,
einem isolierenden Film (16), der auf der Halbleiterschicht gebildet ist,
einer Gateelektrode (17), die auf dem isolierenden Film gebildet ist, und
Source- und Drainelektroden (18, 19) in Kontakt mit den Source- bzw. Drainbereichen, wobei wenigstens eine der Source- oder Drainelektroden mit der Halbleiterschicht in Berührung steht.

2. Anordnung nach Anspruch 1, bei welcher die Halbleiterschicht ein amorpher Halbleiter ist.

3. Anordnung nach Anspruch 2, bei welcher die Halbleiterschicht aus amorphem Silizium besteht.

4. Anordnung nach Anspruch 1, 2 oder 3, mit einem weiteren isolierenden Film (14) zwischen dem Substrat und der Halbleiterschicht.

5. Anordnung nach Anspruch 4, bei welcher der weitere isolierende Film aus Siliziumdioxid oder Siliziumnitrid besteht.

6. Anordnung nach einem der vorhergehenden Ansprüche, bei welcher wenigstens eine der Source- oder Drainelektroden die Grenzschicht zwischen der Halbleiterschicht und dem darauf gebildeten isolierenden Film kontaktiert.

**Revendications**

1. Dispositif de mémoire semiconducteur comprenant:
un substrat semiconducteur (10) d'un premier type de conductivité,
des régions (12, 13) de source et de drain d'un deuxième type de conductivité, opposé au premier type de conductivité, formées dans le substrat,
une couche semiconductrice (15) faite d'un matériau qui est isolant dans les conditions de fonctionnement normales, mais qui est conducteur et permet l'injection ou l'injection de charges lorsqu'il est soumis à un champ électrique d'une intensité supérieure à une valeur particulière, le matériau présentant des niveaux énergétiques permettant le piégeage de charges, le couche semiconductrice étant formée entre les régions de source et de drain au-dessus du substrat,
une pellicule isolante (16) formée sur la couche semiconductrice,
une électrode de grille (17) formée sur la pellicule isolante, et
des électrodes (18, 19) de source et de drain respectivement en contact avec les régions de source et de drain, au moins l'une des électrodes de source et de drain étant en contact avec la couche semiconductrice.

2. Dispositif selon la revendication 1, où la couche semiconductrice est faite d'un semiconducteur amorphe.

3. Dispositif selon la revendication 2, où la couche semiconductrice est faite de silicium amorphe.

4. Dispositif selon la revendication 1, 2 ou 3, comprenant une pellicule isolante (14) supplémentaire entre le substrat et la couche semiconductrice.

5. Dispositif selon la revendication 4, où le pellicule isolante supplémentaire est faite de dioxyde de silicium ou de nitrure de silicium.

6. Dispositif selon l'une quelconque des revendications précédentes, où au moins une des électrodes de source et de drain est en contact avec l'interface formée entre la couche semiconductrice et la pellicule isolante formée sur celle-ci.